# EUROPEAN PATENT APPLICATION

(11) **EP 0 933 639 A2**
(43) Date of publication of application: **04.08.1999**
(21) Application number: 99660004.5
(22) Date of filing: 14.01.1999
(51) Int. Cl.: G01R 15/18, H01F 27/36, H01F 38/36

(54) **Insulating device for rogowski current measuring apparatus**

(30) Priority: 30.01.1998 FI 980222
(71) Applicant: ABB Transmit Oy, 65320 Vaasa (FI)
(72) Inventor: Viitasalo, Jukka, 65370 Vaasa (FI)
(74) Representative: Peltonen, Antti Sakari

(57) **Abstract**

The invention relates to an insulating object comprising a lead-in primary conductor, an insulating body (2), a primary conductor (1) centrally lead through the body (2), and, arranged about the primary conductor, a Rogowski sensor constituting a current measuring element (3) encased in a screen structure (5) having at least one breakpoint. In accordance with the invention, the coil or coils of the Rogowski sensor are made to rest on an insulating casing (4, 4A, 48), and said screen structure (5) is arranged to encircle said insulating casing (4, 4A, 4B).

## Description

### BACKGROUND OF THE INVENTION

The present invention relates to an insulating object comprising a lead-in primary conductor, an insulating body, a primary conductor centrally lead through the body, and, arranged about the primary conductor, a Rogowski sensor constituting a current measuring element encased in a screen structure having at least one breakpoint.

In the context of the present invention, an insulating object comprising a lead-in primary conductor refers to components having such a structure and used particularly as components in electrical apparatuses, such as lead-in insulators, composite sensors, parts of switches and the like. However, for the sake of clarity, the invention will be described below in association with what is likely to be its commonest application, that is, a lead-in insulator.

Insulating objects of the type described in the introduction are known for example from Finnish patent application 921737, European patent application 698897 and German Offenlegungsschrift 3544508. In the lead-in insulator of the first publication, the coil of a Rogowski sensor is placed inside a metal two-piece casing and cast in the casing by cast resin. The whole thus obtained is then cast in the lead-in insulator. The problem here is to ensure electric insulation, i.e. that sufficient insulating clearance remains between the coil and the casing. To ensure this, insulating material or corrugated cardboard has to be used to keep the coil in place until the cast resin is cured. Furthermore, a capacitive voltage sensor is a separate component, which also has to be positioned in the casting mould when the insulator is being cast. The current transformer known from EP 698897 also involves a similar structure and the same problems. In this solution, too, the coil has to be cast inside the metal casing encircling it and supported in place during the cast until the cast is cured. The publication also discloses a structure having metal foil instead of a metal casing, but even in that case the coil has to be cast accurately inside the mass irrespective of whether the foil is positioned in place before or after casting. DE 3544508 again discloses a solution in which the coil is insulated by lacquer-isolated thread and encased in a metal foil whose surface facing the coil is provided with an insulant. This solution employs no actual casing.

In the above, like in all other known lead-in insulator solutions for measuring current passing through an insulator, the problem is the required accurate placement of the current sensor in the vicinity of the primary conductor. The location and position of the current sensor with respect to the primary conductor affect the accuracy and reliability of the measuring results. The sensor is fixedly positioned within the insulator, which makes it impossible to later correct any inclination in the position of the sensor that has occurred during casting. If one or more other sensors, e.g. for voltage measurement and detection, are disposed in the same insulator in addition to the current sensor, then it becomes very problematic to position these sensors with respect to each other and to keep them so positioned during casting of the insulator body.

Insulating objects of the type disclosed in the present invention are typically used in surroundings causing interference to sensitive current measuring elements. Particularly transformers and devices generally used in industrial electricity transmission interfere with measurements. Any interference to sensors, particularly electromagnetic radiation, is to be prevented in order for the measuring results obtained from sensors to represent the magnitude being measured.

### BRIEF DESCRIPTION OF THE INVENTION

It is an object of the present invention to provide an insulating object which avoids the above disadvantages and operates reliably even in demanding circumstances. The objects of the invention are achieved with an insulating object which is characterized by what is disclosed in the independent claims. The preferred embodiments of the invention are disclosed in the dependent claims.

The invention is based on combining a reliable current sensor with the insulating object by making the Rogowski coils rest on an insulating casing cast within the insulator. The casing comprises exact locations where one or more coils of the current sensor are to be placed, facilitating the placement of a coil or coils about the primary conductor.

Because the casing for the current sensor is cast in the object, it is particularly advantageous even for supporting other sensors, e.g. voltage sensors. The casing allows accurate determination of the positions of all the sensors resting on it with respect to each other and to the primary conductor. The exact locations of the sensors are also maintained when the object is being cast, making the measuring results obtained by the sensors reliable.

The insulating casing comprising the current measuring coils is encased in a screen structure for preventing the measurements to be performed in the insulator from being distorted by the action of external interference. The screening implemented in accordance with the invention is simple and inexpensive, yet secure and reliable.

### BRIEF DESCRIPTION OF THE DRAWINGS

In the following the invention will be described in greater detail in association with preferred embodiments with reference to the attached drawings, in which
Figure 1 is a profile of a lead-in insulator constituting an exemplary embodiment of the invention;
Figure 2 is a cross section of the lead-in insulator of Figure 1 taken along line A - A;
Figures 3 and 4 show parts of the insulating casing forming part of the lead-in insulator;
Figure 5 is a perspective view of the insulating casing of Figures 3 and 4; and
Figures 6 and 7 show how the metallization of the surface of the insulating casing ends.

### DETAILED DESCRIPTION OF THE INVENTION

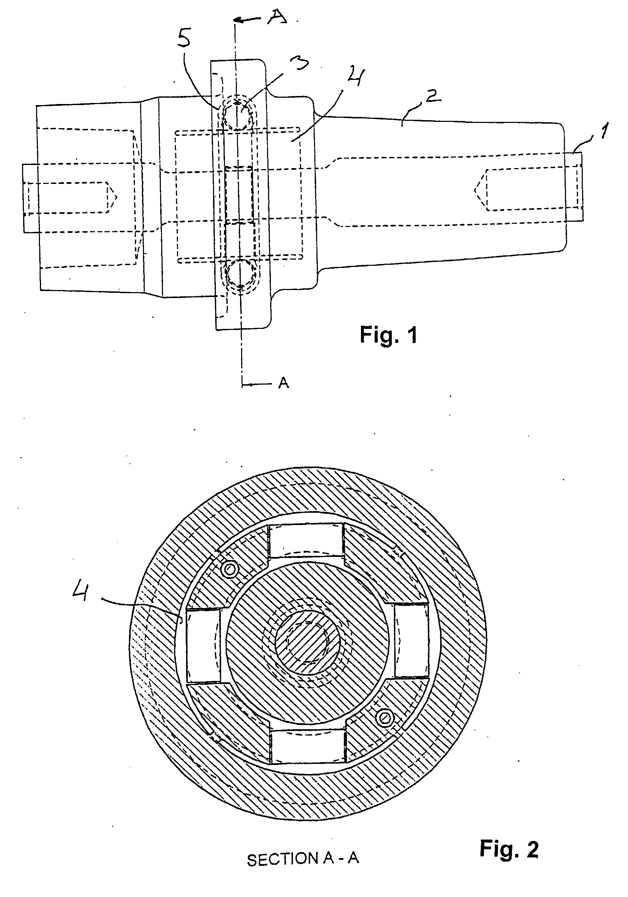

The lead-in insulator of Figure 1 comprises a body 2 through which a primary conductor 1 is led. The lead-in insulator of the embodiment further comprises an insulating casing 4, against the inside of which current measuring element or elements 3 rest. The casing 4 is composed of two parts 4A, 4B, which, joined together, form a tight bedding for the sensors to be placed in the casing. The insulating casing comprises accurately shaped locations 9 for partial coils forming the Rogowski sensor, the coils in Figures 2 and 4 being straight coils, or alternatively for one toroidal coil, whereby it is simple to place the coil or coils in exactly the right places. Routes to the insulating casing 4 may also be prepared beforehand for coupling conductors between different part-windings and any separate return conductor. Exact placement of coupling conductors inside the casing allows the coils to be always mounted exactly in the same position, improving measuring accuracy.

When the casing is made of an insulating material, e.g. plastic, the measuring coil or coils can be placed very close by, or even in contact with the inner wall of the casing, the plastic casing acting as an insulant. A plastic casing thus allows a simple solution for the placement of coils.

To ensure a reliable current measurement by a Rogowski sensor, the sensor must be protected against external interference. The protection can be implemented by making the surface of the casing 4 conductive around the coils. The screen structure can be either of metal film, net or sheet, or a metal coating 5 on the surface of the casing. A separate protective metal casing of e.g. aluminium can also be placed on top of the plastic casing as a screen. The screen has to be provided with at least one breakpoint in order for it to operate as required, i.e. for it not to form a closed loop around the coils.

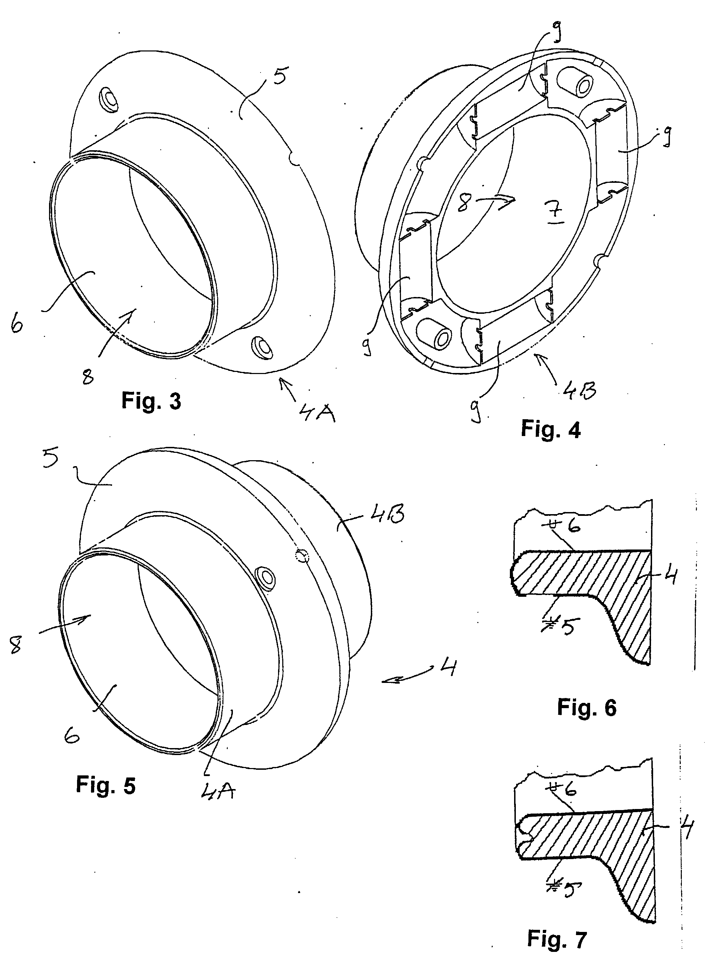

In the embodiment of Figures 3, 4 and 5, the casing 4 is provided with a straight cylindrical part 8, the structure preventing a closed loop from being formed around the coil. Should the structure of the casing not comprise a straight portion, and should some portion of it be of a conductive material, a closed loop can be avoided e.g. by making one edge of the casing slightly lower than the other. Accordingly, when the halves 4A and 4B are joined, no closed loop is formed. The addition of a separate isolation between one counter surface of the casing also prevents the formation of a conductive loop around the coil. The breakpoint required by the operation of the screen can be provided by removing metallization from around the case. The metallization can be removed from a narrow annular area along the entire casing, whereby the location of the small opening in the metallization of the casing can be selected optimally with regard to interference. The formation of a conductive loop can be prevented already in the metallization process by protecting a narrow annular casing area, in which the breakpoint is to be arranged.

The parts 4A and 4B of the casing according to Figures 3 and 4 are joined together, the whole forming a casing 4 shown in Figure 5. The parts of the casing are so joined that the screen surfaces are electrically coupled to one another. The halves can be joined together by e.g. a screw joint, such as is shown in the embodiment of the figures, by gluing, or the casing parts can be arranged to be engaged by e.g. a tongue locking the halves together when they are pressed against one another. Separate fastening points arranged on the surface of the casing can also provide the fastening.

The use of a screw joint ensures a firm fastening of the casing halves 4A and 4B, and a reliable electric contact between them. Base plates can be used below the screws for blocking below them part of the conductive surface and for forming the contact. In addition, the inner surface of the casing may comprise controls with which the casing halves are accurately aligned during installation. Furthermore, the edge of the casing halves may comprise semi-circular recesses which, after the halves are joined, form a full circle. The opening thus formed allows the measuring wires to be brought out from inside the casing for utilization of the measuring results.

After the casing halves 4A, 4B are joined, the casing 4 is cast in resin, whereupon the actual insulator structure is created. For the casting the casing 4 is supported in place in the mould. The casing can be supported in the mould e.g. by the use of supports fastened under the fastening screws of the casing halves or by other means to make the casing remain reliably in place during casting. Casting in resin is carried out e.g. by vacuum moulding, whereby the resin penetrates the casing through the holes in the casing, filling all empty cavities. This way both the casing and the components inside the casing remain tightly in place in the insulator.

In accordance with an embodiment of the invention, the insulator also comprises a voltage measuring element 6 for determining the voltage of the primary conductor 1 of the insulator. The dimensions of the casing, which comprises a current measuring element, are arranged such that the voltage measuring element is placed on the inner surface of the casing. In accordance with the embodiment, voltage is measured by a voltage division-based cylindrical sensor resting on the straight portion 8, which is parallel to the primary conductor 1 of the casing 4 and disposed closest opposite to it.

The voltage measuring element 6 may be any suitable conductor or semiconductor placed inside the casing. According to an embodiment of the invention the voltage measuring element is made by metallization of the inner surface of the casing 4 in the desired area. The use of metallization as a voltage measuring element requires no separate elements inside the casing 4.

According to an embodiment, the sensor required for voltage measurement comprises two voltage measuring elements 6 and 7. One of them is used for measuring voltage amplitude and the other only for detecting the presence of voltage. This provides very reliable voltage detection. In accordance with the embodiment, the elements 6 and 7 are arranged to be supported by the same straight portion 8 of the casing 4 and to be positioned apart in the axial direction of the primary conductor 1. Both measuring elements 6 and 7 can be either metallization on the interior surface of the casing or other suitable components. The operation of the voltage measuring element is based on e.g. capacitive voltage division, but other alternatives for voltage determination are also feasible.

When a sensor based on capacitive voltage division is used, care should be taken that the electric field does not grow too large in some part of the capacitive sensor. There is a tendency for an electric field to grow at the sharp edges of conductive surfaces. Such a point is created if the metalled surface at the inner edge of the casing has no roundings. The edges of the metallizations 5 and 6 of the surfaces of the casing 4 can be formed in accordance with Figures 6 and 7 so that the electric field remains homogenous in the entire area of the conductive material.

In Figure 6 the length of the metallization 6 has been increased by making the edge of the capacitive element formed by the metallization bend along the rounding at the end of the straight portion 8 of the casing 4. Figure 7 shows another alternative with both metallizations 5 and 6 rounded at the end of the straight portion 8 of the case. Such bending allows a better screening since the metallization 5 of the outer surface entirely covers the metallization 6 of the inner surface. The metallization of the outer surface acts as a grounded screen for both the current and the voltage sensors.

The shape of the casing 4 is optimized for the space to be used. The coils have specific placement points in the casing, but the rest of the casing may have any shape. According to an embodiment, the coils of the Rogowski sensor are concentrically placed around the voltage measuring element 6, 7, whereby the cross section of the structure of the insulator is symmetric.

It will be obvious to a person skilled in the art that the basic idea of the invention can be implemented in a variety of ways. Thus the invention and its embodiments are not restricted to the above examples but may vary within the scope of the claims.

## Claims

1. An insulating object comprising a lead-in primary conductor, an insulating body (2), a primary conductor (1) centrally lead through the body (2), and, arranged about the primary conductor, a Rogowski sensor constituting a current measuring element (3) encased in a screen structure (5) having at least one breakpoint, **characterized** in that the coil or coils of the Rogowski sensor rest on an insulating casing (4, 4A, 4B) and that said screen structure (5) is arranged to encircle said insulating casing (4, 4A, 4B).

2. An object as claimed in claim 1, **characterized** in that the screen structure comprises metallization (5) arranged on the surface of the insulating casing.

3. An object as claimed in claim 1, which further comprises at least one voltage division-based voltage measuring element (6) arranged about the primary conductor, **characterized** in that the insulating casing comprises on its surface facing the primary conductor a straight portion (8) which is parallel to the primary conductor (1) and on which the voltage measuring element (6) is resting.

4. An object as claimed in claim 3, **characterized** in that the voltage measuring element comprises metallization (6) in said straight portion (8) of the insulating casing (4).

5. An object as claimed in claim 3 or 4, comprising two voltage measuring elements (6, 7), **characterized** in that the second voltage measuring element (7) is arranged to penetrate the same straight portion (8) of the insulating casing as the first voltage measuring element (6) and to be apart from it in the axial direction of the primary conductor.

6. An object as claimed in claim 5, **characterized** in that the second voltage measuring element comprises metallization (7) on said straight portion (8) of the insulating casing.

7. An object as claimed in any one of claims 3 to 6, **characterized** in that the coil or coils of the Rogowski sensor are arranged concentrically around the voltage measuring element (6, 7).

8. An object as claimed in any one of claims 1 to 7, **characterized** in that the Rogowski sensor comprises a plurality of series coupled coils wound on bobbins arranged in the shape of a polygon around the primary conductor (1) of the insulator and perpendicularly with respect to its axial direction.

9. An object as claimed in any one of claims 1 to 8, **characterized** in that the insulating casing (4) comprises two halves (4A, 4B) which are joined together so that their cross section does not form a closed loop.
